# EUROPEAN PATENT APPLICATION

(11) **EP 4 769 854 A1**
(43) Date of publication of application: **01.07.2026**
(21) Application number: 24887322.6
(22) Date of filing: 15.05.2024
(51) Int. Cl.: H02B 13/065, H02B 13/075, G01R 31/00

(54) **GAS-INSULATED RING MAIN UNIT AND GROUNDING SWITCH**

(30) Priority: 10.11.2023 CN 202311496723
(71) Applicant: XJ Delishier Electric Co., Ltd., Xuchang, Henan 461000 (CN)
(72) Inventor: WU, Xiaozhao, Xuchang, Henan 461000 (CN); LI, Peng, Xuchang, Henan 461000 (CN); DU, Lianjie, Xuchang, Henan 461000 (CN); LI, Changpeng, Xuchang, Henan 461000 (CN); TANG, Qingshuang, Xuchang, Henan 461000 (CN); ZHAO, Ying, Xuchang, Henan 461000 (CN); CUI, Yu, Xuchang, Henan 461000 (CN); ZHI, Jiaojiao, Xuchang, Henan 461000 (CN); ZHANG, Lei, Xuchang, Henan 461000 (CN); ZONG, Hengda, Xuchang, Henan 461000 (CN); WANG, Shuaipu, Xuchang, Henan 461000 (CN)
(74) Representative: Gille Hrabal Partnerschaftsgesellschaft mbB Patentanwälte
(86) International application number: PCT/CN2024/093383
(87) International publication number: WO 2025/097698

(57) **Abstract**

The present invention relates to a gas-insulated ring main unit and a grounding switch, which belongs to the field of high-voltage switchgear technologies. In the prior art, when a cable in a ring main unit needs to be overhauled, the cable needs to be removed from a wall bushing, then a withstand voltage test or a current-carrying test is performed, and the cable is reinstalled after the test is completed, resulting in a troublesome overhaul process. The present invention includes grounding contacts in one-to-one correspondence with outgoing cables of all phases. A grounding side of each of the grounding contacts is connected to an outer side of a gas box through a connecting conductor, and then connected to a grounding busbar. The grounding busbar is connected to the ground. When a cable on a power supply circuit of the grounding busbar needs to be tested or overhauled, only the grounding busbar needs to be removed, which significantly simplifies the overhaul process.

## Description

### TECHNICAL FIELD

The present invention relates to a gas-insulated ring main unit and a grounding switch, which belongs to the field of high-voltage switchgear technologies.

### BACKGROUND

Gas-insulated ring main units are widely used in the field of high-voltage switchgears. However, sometimes a cable on a power supply circuit thereof needs to be tested or overhauled. A conventional gas-insulated ring main unit generally includes a sealed gas chamber. An arc-extinguishing chamber and a three-position switch that are connected in series through a flexible connection are arranged in the sealed gas chamber. The three-position switch includes a fixed isolating contact, a moving isolating contact, and a fixed grounding contact, a grounding busbar is arranged on a side of the fixed grounding contact, and all the components are sealed in a metal gas box. A grounding incoming/outgoing line connected to the grounding busbar is routed using a cable through a wall bushing on a wall of the sealed gas chamber for outgoing grounding.

For example, Chinese Patent Application with the publication No. CN116666147A discloses a linked switch and a ring main unit. The linked switch includes an arc-extinguishing chamber and a three-position switch. A fixed isolating contact of the three-position switch in a gas box is electrically connected to a bus bushing through a bus-side branch bar. A fixed grounding contact is arranged on a grounding busbar in the gas box. An outgoing-side branch bar is connected to an outgoing bushing and is led out of the gas box. Chinese Patent with the Authorization Publication No. CN219677926U discloses a load switch ring main unit. A load switch includes a grounding switch crossbar for grounding. The grounding switch crossbar has a function of grounding and converging each phase line, and is arranged on an inner side of a gas box.

In the foregoing solution, when an outgoing cable needs to be tested, the outgoing cable needs to be removed from the wall bushing on the gas box, and then a withstand voltage test or a current-carrying test is performed and a fault in a circuit is located. The outgoing cable is reinstalled after the test is completed. Throughout the overhaul process, a main cable needs to be removed in a cable room, which is relatively troublesome. In addition, safety of an operator is affected to some extent when the cable is removed.

### SUMMARY

An objective of the present invention is to provide a gas-insulated ring main unit and a grounding switch, so as to solve a problem that an operation process of testing and overhauling a cable on an outgoing side is relatively troublesome.

To achieve the foregoing objective, the present invention includes the following solution.

A grounding switch is provided, including grounding contacts in one-to-one correspondence with outgoing cables of all phases, where a grounding side of each of the grounding contacts is connected to an outer side of a gas box through a connecting conductor and then connected to a grounding busbar, and the grounding busbar is connected to the ground.

In the present invention, a busbar for grounding is arranged on the outer side of the gas box, and a grounding contact that can be connected to a cable of each phase through a grounding breaker is connected to the outer side of the gas box through the connecting conductor, and is further connected to the busbar. Connecting conductors of all phases connected to the busbar can be respectively electrically connected to the cables of all phases through the grounding breakers, and have a function of performing a current-carrying test on the cables of all the phases when the busbar is removed. Without affecting grounding of the grounding switch, when an outgoing cable connected upon closing of the grounding contact needs to be overhauled or tested, only the busbar needs to be removed. In this process, a main cable does not need to be taken out of a cable room, thereby simplifying operation and greatly improving safety of an operator.

Further, bushings in one-to-one correspondence with all the phases are provided through a side wall of the gas box, a grounding side of the connecting conductor is connected to one end, located inside the gas box, of each bushing, and an other end, located outside the gas box, of each bushing is connected to the grounding busbar.

An electrical connector such as a wall bushing is arranged to connect the connecting conductor of the grounding contact in the gas box to the busbar outside the gas box, resulting in a simple structure. After the busbar is removed, a withstand voltage test or a current-carrying test may be performed through a corresponding interface of the bushing at the outer side of the gas box, which is convenient in operation.

Further, the grounding contacts include fixed grounding contacts and moving grounding contacts, the moving grounding contacts are respectively connected to the outgoing cables of all the phases, and the fixed grounding contacts serve as the grounding side for connection to the ground.

The fixed grounding contacts serve as the grounding side for connection to the ground. Because a structure at the fixed grounding contacts is simple, it is more convenient to make a modification at the fixed grounding contacts, and a design structure is simple.

Further, the connecting conductor is arranged on an insulating fixing member for fixing the fixed grounding contact, the connecting conductor includes a fixing side, and the fixing side is connected to the fixed grounding contact fixed to the insulating fixing member.

The connecting conductor is fixed to the insulating fixing member to which the fixed grounding contact is fixed, so that the structure is more stable.

Further, the connecting conductor and the fixed grounding contact are arranged on one side of the insulating fixing member.

The connecting conductor and the fixed grounding contact are arranged on one side of the insulating fixing member, so that the connection is more convenient and the conductivity is better.

Further, the fixing side of the connecting conductor and a fixing portion of the fixed grounding contact are fastened to the insulating fixing member through bolts.

The connecting conductor and the fixed grounding contact are fastened through the bolts, so that a fixing manner is simple and stability is good.

Further, the connecting conductor is a copper connecting rod.

The connecting conductor is set as the copper connecting rod. Compared to other conductors, the copper connecting rod has good electrical conductivity, and is cost-effective.

A gas-insulated ring main unit is provided, including a grounding switch. The grounding switch includes grounding contacts in one-to-one correspondence with outgoing cables of all phases, where a grounding side of each of the grounding contacts is connected to an outer side of a gas box through a connecting conductor and then connected to a grounding busbar, and the grounding busbar is connected to the ground.

In the present invention, the busbar for grounding is arranged on the outer side the gas box, and the grounding contact that can be connected to the cable of each phase through the grounding breaker is connected to the outer side of the gas box through the connecting conductor, and is further connected to the busbar. Connecting conductors of all phases connected to the busbar can be respectively electrically connected to the cables of all phases through the grounding breakers, and have a function of performing a current-carrying test on the cables of all the phases when the busbar is removed. Without affecting grounding of the grounding switch, as an outgoing cable connected when the grounding contact is closed needs to be overhauled or tested, only the busbar needs to be removed. In this process, a main cable does not need to be taken out of a cable room, thereby simplifying operation and greatly improving safety of an operator.

Further, bushings in one-to-one correspondence with all the phases are provided through a side wall of the gas box, a grounding side of the connecting conductor is connected to one end, located inside the gas box, of each bushing, and an other end, located outside the gas box, of each bushing is connected to the grounding busbar.

An electrical connector such as a wall bushing is arranged to connect the connecting conductor of the grounding contact in the gas box to the busbar outside the gas box, resulting in a simple structure. After the busbar is removed, a withstand voltage test or a current-carrying test may be performed through a corresponding interface of the bushing at the outer side of the gas box, which is convenient in operation.

Further, the grounding contacts include fixed grounding contacts and moving grounding contacts, the moving grounding contacts are respectively connected to the outgoing cables of all the phases, and the fixed grounding contacts serve as the grounding side for connection to the ground.

The fixed grounding contacts serve as the grounding side for connection to the ground. Because a structure at the fixed grounding contacts is simple, it is more convenient to make a modification at the fixed grounding contacts, and a design structure is simple.

Further, the connecting conductor is arranged on an insulating fixing member for fixing the fixed grounding contact, the connecting conductor includes a fixing side, and the fixing side is connected to the fixed grounding contact fixed to the insulating fixing member.

The connecting conductor is fixed to the insulating fixing member to which the fixed grounding contact is fixed, so that the structure is more stable.

Further, the connecting conductor and the fixed grounding contact are arranged on one side of the insulating fixing member.

The connecting conductor and the fixed grounding contact are arranged on one side of the insulating fixing member, so that the connection is more convenient and the conductivity is better.

Further, the fixing side of the connecting conductor and a fixing portion of the fixed grounding contact are fixed to the insulating fixing member through bolts.

The connecting conductor is fixed to the fixed grounding contact through the bolts, so that a fixing manner is simple and stability is good.

Further, the connecting conductor is a copper connecting rod.

The connecting conductor is set as the copper connecting rod. Compared to other conductors, the copper connecting rod has good electrical conductivity, and is cost-effective.

### BRIEF DESCRIPTION OF THE DRAWINGS

FIG. 1 is a schematic structural diagram of an open state of a grounding switch for a gas-insulated ring main unit;
FIG. 2 is a schematic structural diagram of a grounding circuit assembly in FIG. 1; and
FIG. 3 is a schematic structural diagram of a closed state of a grounding switch for a gas-insulated ring main unit after a busbar is removed according to the present invention.

In the figure: 1. Fixed contact base; 2. Moving grounding contact; 3. Fixed grounding contact; 4. Insulating fixing member; 5. Connecting conductor; 6. Bushing; 7. Busbar; 8. Gas box wall.

### DETAILED DESCRIPTION

To make objectives, technical solutions, and advantages of the present invention clearer, the present invention is further described in detail below with reference to the accompanying drawings and embodiments.

The idea of the present invention is that a busbar for grounding is arranged on an outer side of a gas box, the grounding busbar is connected to the ground, and grounding contacts corresponding to outgoing cables of all phase lines in the gas box are connected to the grounding busbar arranged on the outer side of the gas box through connecting conductors. In the present invention, without affecting grounding of an original grounding switch, insulation and current-carrying performance of a cable in a power supply circuit of a ring main unit may be further tested, and a fault in the circuit may be located. When an overhaul is needed, the grounding busbar is removed, and the grounding contact is closed. In this process, a main cable does not need to be taken out of a cable room, thereby greatly improving safety of an operator.

### Grounding switch embodiment 1:

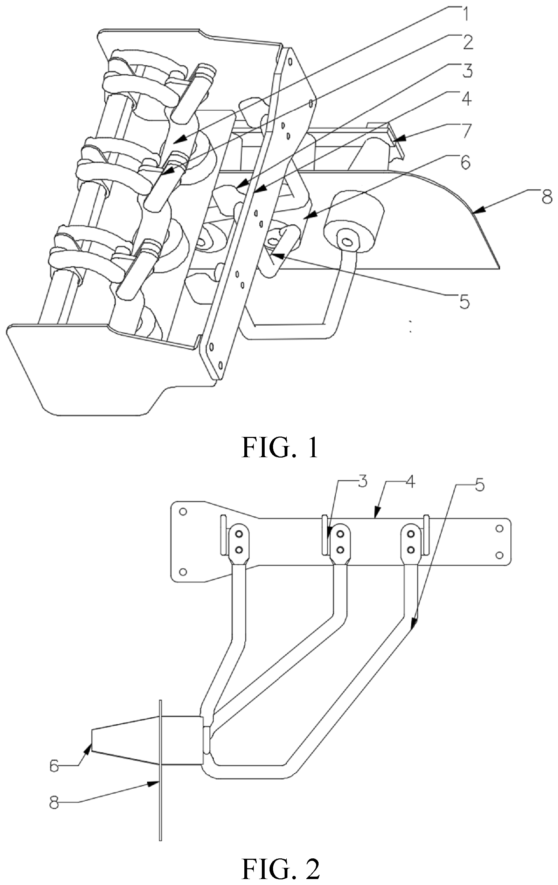

An embodiment of a grounding switch of the present invention is shown in FIG. 1. The grounding switch includes a fixed contact base 1, moving grounding contacts 2, fixed grounding contacts 3, an insulating fixing member 4, connecting conductors 5, bushings 6, a busbar 7, and a gas box wall 8.

The fixed grounding contact 3 and the connecting conductor 5 are both fixed to a side surface of the insulating fixing member 4. The moving grounding contacts 2 in one-to-one correspondence with the fixed grounding contacts are fixed to the fixed contact base 1. An other end of the fixed contact base 1 is connected to outgoing cables of all phases. In this embodiment, the insulating fixing member 4 fixes the fixed grounding contact 3 and the connecting conductor 4 through an insulating fixing board. In this embodiment, the connecting conductor 4 is connected to the fixed grounding contact 3 through a copper connecting rod.

A manner of fixing the copper connecting rod 5 and the fixed grounding contact to the insulating fixing board 4 is further described. As shown in FIG. 2, two fixing holes are provided on the insulating fixing board 4, and a fixing portion of the fixed grounding contact 3 on a side of the insulating fixing board 4 and a fixing side of the copper connecting rod 5 are simultaneously pressed and connected through a bolt passing through each fixing hole, so that the fixed grounding contact 3 and the copper connecting rod 5 are more stably fixed. In another embodiment, the fixed grounding contact 3 may alternatively be soldered to the insulating fixing board 4, and the copper connecting rod 5 is fixed to a side of the fixed grounding contact 3 through the fixing holes and is connected to the fixed grounding contact 3.

Holes through which three bushings 6 corresponding to three phase lines pass are provided through the gas box wall. The three bushings are mounted through the gas box wall 8 by soldering nuts and bolts on the gas box wall 8. One end of each bushing located inside the gas box is respectively connected to one end of each copper connecting rod 5 away from the fixed grounding contacts 3, and an other end of each bushing located outside the gas box is connected to the busbar 7.

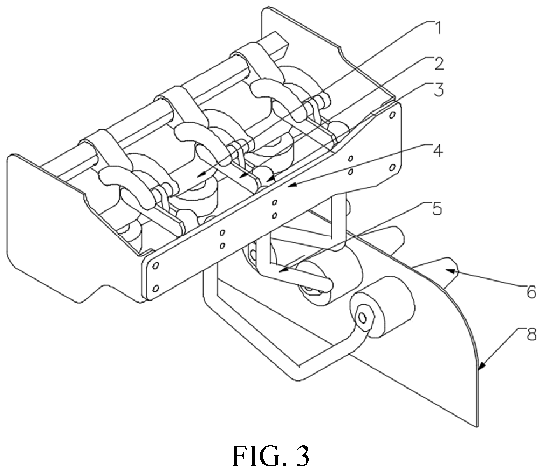

As shown in FIG. 3, when the grounding switch is closed, that is, the moving grounding contact 2 rotates to the fixed grounding contact 3 and contacts the fixed grounding contact 3, the other end of each bushing 6 located outside the gas box is electrically connected to an outgoing cable connected to the fixed contact base 1. When the grounding switch is opened, as shown in FIG. 1, the other end of each bushing 6 located outside the gas box is disconnected from the outgoing cable connected to the fixed contact base 1. When a cable needs to be tested or overhauled, the grounding switch is in a closed position, the busbar 7 is removed, and an insulation test or a current-carrying test is performed through the three-phase bushing 6 on the outgoing cable connected to the fixed contact base 1. In this process, no other parts of the box need to be specifically removed, and the test or the overhaul may be performed by only removing the busbar 7 on the outer side of the box, which is simple in operation.

### Grounding switch embodiment 2:

A difference between a grounding switch embodiment of the present invention and the embodiment 1 lies in that a moving grounding contact in a grounding contact is connected to the ground as a grounding side, the grounding side is connected to a busbar outside a gas box through a connecting conductor, and a fixed grounding contact in the grounding contact is connected to an outgoing cable of each phase.

### Ring main unit embodiment:

An embodiment of a gas-insulated ring main unit of the present invention includes a grounding switch. The grounding switch is described in detail in the foregoing grounding switch embodiments 1 and 2. Details are not described herein again.

## Claims

1. A grounding switch, comprising grounding contacts in one-to-one correspondence with outgoing cables of all phases, wherein a grounding side of each of the grounding contacts is connected to an outer side of a gas box through a connecting conductor and then connected to a grounding busbar, and the grounding busbar is connected to the ground.

2. The grounding switch according to claim 1, wherein bushings in one-to-one correspondence with all the phases are provided through a side wall of the gas box, a grounding side of the connecting conductor is connected to one end of each bushing located inside the gas box, and an other end of each bushing located outside the gas box is connected to the grounding busbar.

3. The grounding switch according to claim 1, wherein the grounding contacts comprise fixed grounding contacts and moving grounding contacts, the moving grounding contacts are respectively connected to the outgoing cables of all the phases, and the fixed grounding contacts serve as the grounding side for connection to the ground.

4. The grounding switch according to claim 1, wherein the connecting conductor is arranged on an insulating fixing member for fixing the fixed grounding contact, the connecting conductor comprises a fixing side, and the fixing side is connected to the fixed grounding contact fixed to the insulating fixing member.

5. The grounding switch according to claim 4, wherein the connecting conductor and the fixed grounding contact are arranged on one side of the insulating fixing member.

6. The grounding switch according to claim 5, wherein the fixing side of the connecting conductor and a fixing portion of the fixed grounding contact are fastened to the insulating fixing member through bolts.

7. The grounding switch according to claim 1, wherein the connecting conductor is a copper connecting rod.

8. A gas-insulated ring main unit, comprising the grounding switch according to any one of claims 1 to 7.
